# EUROPEAN PATENT SPECIFICATION

(11) **EP 0 318 555 B1**
(45) Date of publication and mention of the grant of the patent: **15.09.1993**
(21) Application number: 88905313.8
(22) Date of filing: 31.05.1988
(51) Int. Cl.: H01L 21/76

(54) **SEMICONDUCTOR FIELD OXIDE FORMATION PROCESS**
VERFAHREN ZUR HERSTELLUNG EINES HALBLEITERFELDOXIDS
PROCEDE DE FORMATION D'UN OXYDE DE CHAMP SEMICONDUCTEUR

(30) Priority: 15.06.1987 US 61923
(43) Date of publication of application: 07.06.1989
(73) Proprietor: NCR INTERNATIONAL INC., Dayton, Ohio 45479 (US)
(72) Inventor: LEE, Steven, Shao-Lun, Colorado Springs, CO 80915 (US)
(74) Representative: Robinson, Robert George
(86) International application number: US8801787
(87) International publication number: WO8810510

(56) References cited:
- DE-A- 3 402 825
- GB-A- 2 083 947
- JAPANESE JOURNAL OF APPLIED PHYSICS, volume 20, supplement 20-1, 1981, Proceedings of the 12th Conference on Solid State Devices, 1980, (Tokyo, JP), K. Minegishi et al. : "A new self-aligned framed mask method for selective oxidation", pages 55-61, see figures 1,3,5,6.

## Description

### Technical Field

This invention relates to processes of the kind for forming field oxide regions in a semiconductor substrate.

### Background Art

The fabrication of an integrated circuit normally begins by processing the semiconductor substrate or wafer to divide the surface area into first regions, where active devices and substrate imbedded interconnects are to be formed, and second regions of dielectric, which electrically separate the first active regions. The field oxide dielectric material is routinely silicon dioxide. Though various field oxide formation techniques have been developed and described, the technique commonly known as the localized oxidation of silicon (LOCOS) remains prevalent if not dominant within the semiconductor industry. In the practice of LOCOS, the active regions of the silicon substrate are masked by a silicon nitride layer, while the field oxide regions are thermally oxidized to form a field dielectric region. Though fundamentally simple and efficient, the LOCOS process exhibits deficiencies with reduce yield or performance in the final semiconductor chip product.

The most frequently encountered deficiency in the prior art techniques is commonly known as the bird's head or bird's beak problem, wherein the field oxide extends under the masking nit ride layer to consume some of the usable active area.

A number of techniques have been suggested to migrate the bird's head and bird's beak problem. For example, U.S. Patent No. 4,563,227 discloses a process wherein an oxide layer is formed in a Semiconductor substrate, and a nitride layer is formed on the oxide layer. A groove is then formed by anisotropic etching through the formed layers and extending into the substrate. The oxide layer is then side etched. A further oxide layer is grown on the surface of the groove and a further silicon nitride film is formed over the entire surface by chemical vapor deposition (CVD). Using anisotropic dry etching, the further silicon nitride film is removed from horizontal surfaces, including the bottom surface of the groove, but is retained on the sidewalls of the groove. Oxidation then takes place to fill the groove and provide a relatively planar surface without forming a bird's head and bird's beak because of the thick and stable silicon nitride film in the vicinity of the interface between the oxide film and the substrate.

However, the known process has the disadvantages that stress dislocation may occur at the edges of the active regions and notches or grooves may form in the field oxide of sufficient dimension to trap residuals of subsequently deposited conductive materials.

The document Japanese Journal of Applied Physics, volume 20, supplement 20-1, 1981, Proceedings of the 12th Conference on solid State Devices, 1980, (Tokyo, JP), K. Minegishi et al.: "A new self-aligned framed mask method for selective oxidation", pages 55-61, discloses the formation of oxide isolation regions in a semiconductor substrate wherein the initial steps include the formation of a 20-200 nm pad silicon oxide layer, followed by the formation of a 50-200 nm silicon nitride layer. These films are then conventionally etched and covered by a 50-300 nm silicon nitride layer. The second silicon nitride layer is then anistopically etched to leave a nitride frame surrounding the conventionally etched regions, and field oxide growth follows.

### Disclosure of the Invention

It is the object of the present invention to provide a process of the kind specified wherein the bird's head and bird's beak problem is alleviated, and which mitigates the aforementioned disadvantages without undue process complexity.

Therefore, according to the present invention, there is provided a process of the kind specified, including the steps of: forming over the substrate active regions a pad oxide layer and forming over the pad oxide layer a first silicon nitride layer to a thickness of 100 nm or greater, characterized by the steps of: anisotropically etching in the presence of a photoresist mask through the first nitride layer the pad oxide layer, and into the substrate to define field oxide regions with substantially vertical sidewalls; forming a conformal second silicon nitride layer, over the patterned structure of the substrate and layers, to a nominal thickness of 10-13 nm; anisotropically etching the horizontal surfaces of the second silicon nitride layer to expose selected horizontal surfaces of the substrate while retaining second silicon nitride on the substantially vertical sidewalls; oxidizing the exposed substrate and second silicon nitride so as to effectuate oxidation together with bending and lifting of the retained sidewall silicon nitride; continuing the oxidation of the substrate until the upper surface of the oxidize substrate surface approximates the level of the pad oxide layer; and removing any remaining silicon nitride.

Thus, the process according to the invention selectively refines and combines fabrication concepts to suppress the bird's beak formation, provide a relatively planar concluding surface, suppress stress induces dislocations at the edges of the active silicon, and avoid the formation of notches at the edge of the active silicon. These accomplishments are attained with the addition of only one low pressure chemical vapor deposition of nitride step and one anisotropic etching step beyond the steps used to practice the classic LOCOS process.

### Brief Description of the Drawings

One embodiment of the present invention will now be described by way of example, with reference to the accompanying drawings, in which:
Figs. 1-3 are cross-sectional schematic representations of an integrated circuit substrate at various stages in the fabrication sequence prior to field oxide growth.
Figs. 4A-4C schematically illustrate in the cross-section progressive stages of the field oxide growth when practiced according to the present invention.
Fig. 5 schematically illustrates, in cross-section, a composite integrated circuit structure of active regions separated by a field oxide region.

### Best Mode for Carrying Out the Invention

Generally, the process of the present invention utilizes a relatively thick first pad oxide layer under a relatively thick first nitride layer, a very thin conformally deposited second nitride layer with no underlying pad oxide, a match of the growth of the silicon dioxide from the substrate recess with the oxidation consumption of the thin second nitride layer, and a time and position coincidence of the field oxide vertical propagation with the level of the first pad oxide. According to a preferred practice of the invention, the active regions of a silicon substrate are covered with a pad silicon dioxide layer to a thickness in the range of 50 nm or greater and an LPCVD first silicon nitride layer to a nominal thickness of 100 nm or greater, e.g. 200 nm. The structure is then photolithographically processed to retain masking photoresist patterns over the active regions. An RIE or other anisotropic etch thereafter successively removes the unmasked nitride layer, the underlying pad oxide layer, and the silicon substrate to a nominal recess depth of 120 nm, to create trenched regions with substantially vertical sidewalls. The formation of a thin LPCVD silicon nitride layer follows, conformally deposited to a nominal thickness of 13 nm or less. An anisotropic etch to remove silicon nitride from the horizontal surfaces follows next, retaining approximately 12 nm or less of the second silicon nitride layer material on the vertical sidewalls. The field oxide is then grown from the substrate until the lifting/bending and oxidation of the thin sidewall of silicon nitride results in a complete junction of the grown field oxide with the pad oxide.

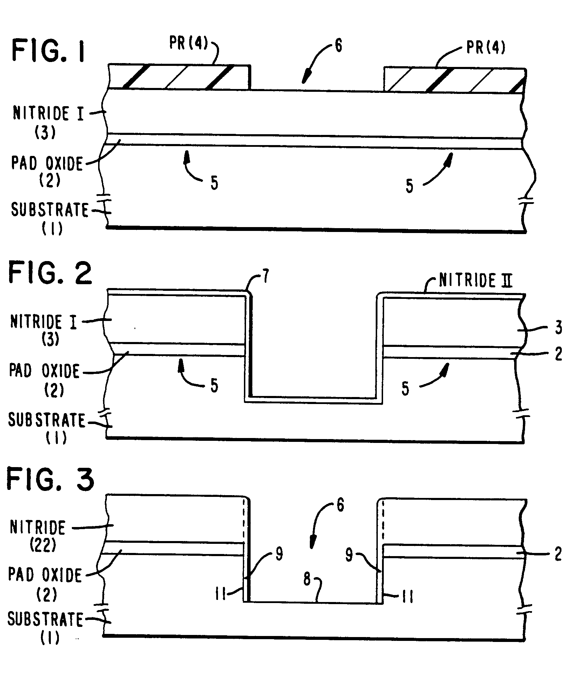

Attention is now directed to the cross-section in Fig. 1 of the drawings, where a preferred practice of the invention is shown as first commenced to form a silicon dioxide dielectric field oxide region in a monocrystalline silicon substrate 1. To create the structure in Fig. 1, the silicon substrate 1 is first thermally oxidized to form a pad oxide layer 2 having a nominal thickness of at least 50 nm, to relieve differential coefficient of expansion stresses. The pad oxide layer 2 actually performs two somewhat distinct functions, the first being the relief of the shear stress, according to normal practice, and second the relief of expansion induced compressive stress at the active region corner, in a manner to be described later.

As further shown in Fig. 1, pad oxide 2 on substrate 1 is then covered by a silicon nitride I layer 3 preferably to a nominal thickness of 200 nm by LPCVD. Thereupon, a photoresist is deposited and photolithographically processed to retain a photoresist (PR) mask pattern 4 exposing nitride I layer 3 at opening 6, generally corresponding to the field oxide formation region between active regions 5 in substrate 1.

To reach the stage of fabrication depicted in Fig. 2, the structure in Fig. 1 is anisotropically etched using a conventional reactive ion etching (RIE) process to remove nitride I layer not masked by photoresist 4, the aligned segment of pad oxide layer 2, and then a section of substrate 1 suitable to form a recess approximately 120 nanometers deep into substrate 1. Following the strip of photoresist 4, substrate 1 is conformally covered by an LPCVD silicon nitride II layer 7 to a nominal thickness of 10-13 nm.

The structure in Fig. 2 is then subjected to another anisotropic etch, this etch serving to remove at least 13 nanometers of silicon nitride from exposed horizontal surfaces. As a consequence of such anisotropic etch, as shown in Fig. 3, the bottom surface 8 of the recess at location 6 in silicon substrate 1 is exposed, while sidewall silicon nitride II layer 9 is retained but thinned by a nominal one nanometer.

Note that no pad oxide underlies sidewall nitride 9, thereby inhibiting the movement of oxygen species along the underside of sidewall nitride layer 9 during thermal field oxide growth. Clearly, oxygen species are also blocked from direct access to pad oxide layer by sidewall nitride layer 9 during the initial stages of field oxide growth. The dimensions of sidewall nitride layer 9 are relatively crucial, not only in controlling the oxidation effects, but also in avoiding coefficient of expansion differential induced stress damage along sidewalls 11 of silicon substrate 1. Namely, sidewall nitride 9 is sufficiently thin at 12 nm to yield rather than cause stress damage to silicon substrate 1. Sidewall 11 is oxidized at a rate suitable to facilitate bending and lifting with silicon dioxide growth, yet is sufficiently thick to block oxidizing species access to the pad oxide region until the specifically desired time.

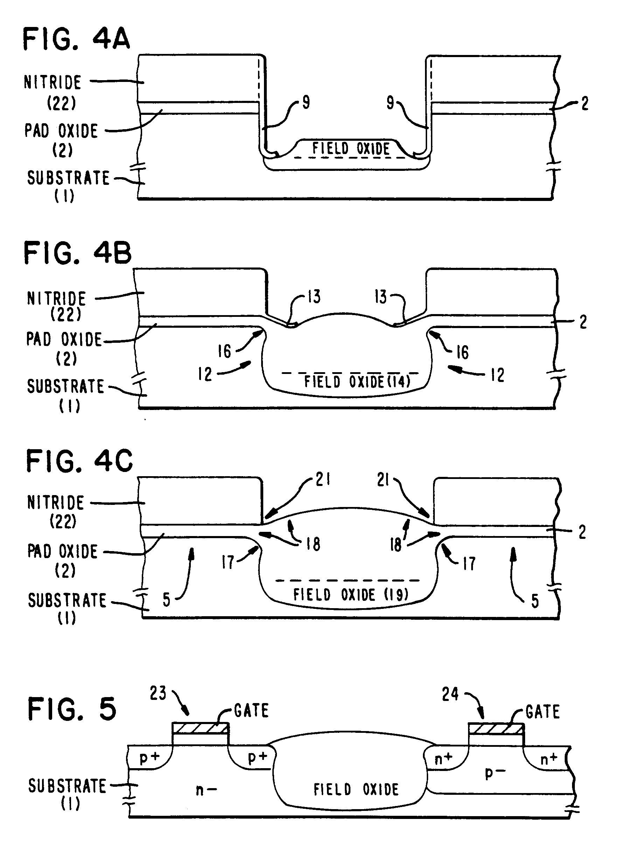

Figs. 4A-4C depict the structure at various stages in the growth of the field oxide, using a preferred field oxidation environment of H₂ + O₂, at a nominal temperature of approximately 900°C for a nominal time of 750 minutes. As the field oxide growth continues in progressing to the structure shown in Fig. 4B, the former sidewall nitride layer 9 is fully lifted and bent. During this time, stress in sidewall regions 12 of silicon substrate 1 is relieved by the presence of the thin sidewall nitride at the commencement of oxidation and its further thinning by surface conversion to oxide during oxidation. At the stage of oxidation depicted in Fig. 4B, nitride layers 13 would be thinned to approximately 3 nm or less.

Fig. 4B also illustrates that the lifting of the residual sidewall silicon nitride 13 exposes the relatively thick pad oxide 2 near the end of oxidation. Pad oxide 2 then serves as a path for relieving volumetric increase stresses in field oxide 14 proximate silicon substrate corners 16, corners which otherwise would be likely to encounter stress induced dislocations. As the field oxide growth continues into the final stage depicted in Fig. 4C, conversion of residual sidewall silicon nitride 13 to oxide opens a relatively short path for oxygen species to reach silicon substrate corners 16. The result is an accentuated oxidation rate at silicon substrate corners 16 to create corners 17 of relatively large radius, smooth contour, and reduced local stress. Again, the relatively thick pad oxide layer 2 provides a yielding path for the relief of localized stresses, which path supplements the vertically directed movement and relief in the region 18. Furthermore, the relatively limited growth of field oxide 19 over the lower corner regions 21 of nitride layer 22, by virtue of the masking by sidewall nitride layer 13 (Fig. 4B), substantially suppresses the formation of notches or grooves in the field oxide at the edges of the active regions 5.

As a consequence of the balanced interaction between the lifting and bending of the sidewall nitride layer, the conversion of the sidewall nitride to an oxide, the relief of stress through the pad oxide, the accentuated conversion of the silicon substrate at the edge of the active region near the conclusion of the oxidation step, and the multidirectional relief of stresses at the relatively rounded edges of the active regions, not only is the bird's beak problem substantially suppressed, but the active region does not experience stress induced dislocations nor does the structure of the field oxide incorporate deleterious notches or grooves. Foremost, the desirable features are obtained by the addition of only two noncritical fabrication steps, through a judicious refinement of dimensions and operations.

Fig. 5 illustrates a representative concluding integrated circuit structure, following the removal of the masking nitride 22 (Fig. 4C) and an oxide layer including pad oxide 2, followed by the selective formation of exemplary CMOS field effect transistors, such as the p-channel device at 23 and the n-channel device at 24.

## Claims

1. A process for forming field oxide regions between active regions (5) in a semiconductor substrate (1), including the steps of: forming over the substrate active regions (5) a pad oxide layer (2) and forming over the pad oxide layer (2) a first silicon nitride layer (3) to a thickness of 100 nm or greater, characterized by the steps of: anisotropically etching in the presence of a photoresist mask (4) through the first nitride layer (3) the pad oxide layer (2), and into the substrate (1) to define field oxide regions (6) with substantially vertical sidewalls (11); forming a conformal second silicon nitride layer (7), over the patterned structure of the substrate and layers, to a nominal thickness of 10-13nm; anisotropically etching the horizontal surfaces of the second silicon nitride layer (7) to expose selected horizontal surfaces of the substrate while retaining second silicon nitride (9) on the substantially vertical sidewalls (11); oxidizing the exposed substrate (1) and second silicon nitride (9) so as to effectuate oxidation together with bending and lifting of the retained sidewall silicon nitride (9); continuing the oxidation of the substrate (1) until the upper surface of the oxidized substrate surface approximates the level of the pad oxide layer (2); and removing the remaining silicon nitride.

2. The process recited in claim 1, characterized in that the anisotropic etch to define the field oxide regions (6) extends into the semiconductor substrate (1) to a depth numerically greater than the thickness dimension of the pad oxide layer (2).

3. The process recited in claim 2, wherein the depth is approximately 120 nm.

4. The process recited in claim 2, characterized in that the thickness of the silicon nitride (9) retained on the substantially vertical sidewalls (11) following the anistotropic etch of the horizontal surfaces is nominally in the range 9-12 nm.

5. The process according to claim 3 or claim 4, characterized in that the substrate (1) is silicon and the sidewall silicon nitride (9) is converted to silicon dioxide when the oxide formed from the substrate (1) reaches the level of the pad oxide layer (2).

## Patentansprüche

1. Ein verfahren zum Ausbilden von Feldoxidgebieten zwischen aktiven Gebieten (5) in einem Halbleitersubstrat (1), mit den Schritten: Ausbilden einer Pufferoxidschicht (2) über den aktiven Gebieten (5) des Substrats und Ausbilden einer ersten Siliziumnitridschicht (3) über der Pufferoxidschicht (2) bis zu einer Dicke von 100 nm oder mehr, gekennzeichnet durch die Schritte: anisotropes Ätzen in Gegenwart eine Fotolackmaske (4) durch die erste Nitridschicht (3) und die Pufferoxidschicht (2) hindurch und in das Substrat (1) hinein zum Festlegen von Feldoxidgebieten (6) mit im wesentlichen vertikalen Seitenwänden (11); Ausbilden einer zweiten gleichmäßigen Siliziumnitridschicht (7) über dem strukturierten Aufbau des Substrats und der Schichten bis zu einer nominellen Dicke von 10 - 13 nm; anisotropes Ätzen der horizontalen Flächen der zweiten Siliziumnitridschicht (7), um ausgewählte horizontale Flächen des Substrats freizulegen, während das zweite Siliziumnitrid (9) an den im wesentlichen vertikalen Seitenwänden (11) beibehalten wird; oxidieren des freigelegten Substrats (1) und des zweiten Siliziumnitrids (9), um somit eine Oxidation zusammen mit einem Biegen und Anheben des zurückbehaltenen Seitenwand-Siliziumnitrids (9) zu verwirklichen; Fortführen der Oxidation des Substrats (1), bis die Oberseite der oxidierten Substratfläche dem Niveau der Pufferoxidschicht (2) angeglichen ist; und Entfernen von etwaigem restlichem Siliziumnitrid.

2. Das Verfahren nach Anspruch 1,
dadurch **gekennzeichnet,**
daß die anisotrope Ätzung zur Festlegung der Feldoxidgebiete (6) sich in das Halbleitersubstrat (1) bis zu einer Tiefe erstreckt, die zahlenmäßig größer als das Maß der Dicke der Pufferoxidschicht (2) ist.

3. Das Verfahren nach Anspruch 2,
wobei die Tiefe etwa 120 nm beträgt.

4. Das Verfahren nach Anspruch 2,
dadurch **gekennzeichnet,**
daß die Dicke des Siliziumnitrids (9), das an den im wesentlichen vertikalen seitenwänden (11) beibehalten ist, nach der anisotropen Ätzung der horizontalen Flächen nominell im Bereich von 9 - 12 nm liegt.

5. Das Verfahren nach Anspruch 3 oder 4,
dadurch **gekennzeichnet,**
daß das Substrat (1) Silizium ist und das seitenwand-Siliziumnitrid (9) in Siliziumdioxid umgewandelt wird, wenn das vom Substrat (1) gebildete Oxid das Niveau der Pufferoxidschicht (2) erreicht.

## Revendications

1. Procédé pour former des régions d'oxyde de champ entre des régions actives (5) dans un substrat semiconducteur (1), comprenant les étapes qui consistent : à former sur les régions actives (5) du substrat, une couche (2) d'oxyde pour plots et à former sur la couche (2) d'oxyde pour plots une première couche (3) de nitrure de silicium à une épaisseur de 100 nm ou plus, caractérisé par les étapes qui consistent : à graver de façon anisotrope, en présence d'un masque (4) de photoréserve, à travers la première couche (3) de nitrure, la couche (2) d'oxyde pour plots et jusque dans le substrat (1) pour définir des régions (6) d'oxyde de champ ayant des parois latérales sensiblement verticales (11) ; à former une seconde couche (7) de nitrure de silicium, sur la structure configurée du substrat et des couches, dont elle épouse la forme, à une épaisseur nominale de 10 à 13 nm ; à graver de façon anisotrope les surfaces horizontales de la seconde couche (7) de nitrure de silicium pour mettre à découvert des surfaces horizontales choisies du substrat tout en retenant un second nitrure (9) de silicium sur les parties latérales sensiblement verticales (11) ; à oxyder le substrat (1) à découvert et le second nitrure de silicium (9) pour effectuer une oxydation en même temps qu'une flexion et un soulèvement du nitrure de silicium retenu (9) des parois latérales ; à continuer l'oxydation du substrat (1) jusqu'à ce que la surface supérieure du substrat oxydé atteigne approximativement le niveau de la couche (2) d'oxyde pour plots ; et à éliminer le nitrure de silicium restant.

2. Procédé selon la revendication 1, caractérisé en ce que la gravure anisotrope pour définir les régions (6) d'oxyde de champ pénètre dans le substrat semiconducteur (1) jusqu'à une épaisseur d'une valeur numérique supérieure à la dimension en épaisseur de la couche (2) d'oxyde pour plots.

3. Procédé selon la revendication 2, dans lequel la profondeur est d'environ 120 nm.

4. Procédé selon la revendication 2, caractérisé en ce que l'épaisseur du nitrure (9) de silicium retenu sur les parois latérales (11) sensiblement verticales à la suite de la gravure anisotrope des surfaces horizontales est d'une valeur nominale comprise entre 9 et 12 nm.

5. Procédé selon la revendication 3 ou la revendication 4, caractérisé en ce que le substrat (1) est en silicium et le nitrure de silicium (9) des parois latérales est transformé en dioxyde de silicium lorsque l'oxyde formé à partir du substrat (1) atteint le niveau de la couche (2) d'oxyde pour plots.
